# FASCICULE DE BREVET EUROPEEN

(11) **EP 3 098 858 B1**
(45) Date de publication et mention de la délivrance du brevet: **25.10.2017**
(21) Numéro de dépôt: 16170359.0
(22) Date de dépôt: 19.05.2016
(51) Int. Cl.: H01L 31/0232, H01L 31/107

(54) **PHOTODÉTECTEUR À HAUT RENDEMENT QUANTIQUE**
FOTOSENSOR MIT HOHER QUANTENEFFIZIENZ
PHOTODETECTOR WITH HIGH QUANTUM EFFICIENCY

(30) Priorité: 29.05.2015 FR 1554878
(43) Date de publication de la demande: 30.11.2016
(73) Titulaire: COMMISSARIAT À L'ÉNERGIE ATOMIQUE ET AUX ÉNERGIES ALTERNATIVES, 75015 Paris (FR); STMicroelectronics SA, 92120 Montrouge (FR)
(72) Inventeur: FREY, Laurent, 38600 Fontaine (FR); MARTY, Michel, 38760 Saint-Paul De Varces (FR)
(74) Mandataire: Thibon, Laurent

(56) Documents cités:
- FR-A1- 2 964 795
- FR-A1- 3 009 889
- US-A1- 2010 308 427

## Description

### Domaine

La présente demande concerne le domaine des photodétecteurs à semiconducteur, et plus particulièrement des photodétecteurs de type photodiode, utilisés par exemple comme pixels d'un capteur d'image, ou comme diodes à avalanche à photon unique.

### Exposé de l'art antérieur

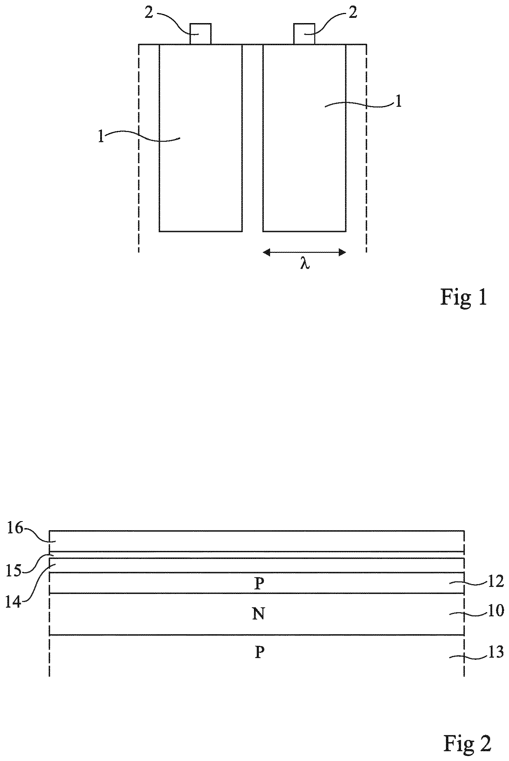

La figure 1 représente de façon simplifiée et partielle deux photodétecteurs côte à côte d'un ensemble de photodétecteurs constituant par exemple un capteur d'image. Chaque photodétecteur comprend une structure semiconductrice 1 de conversion de photons en paires électrons-trous. La structure 1 peut comporter des jonctions (non représentées) entre des régions semiconductrices de types de conductivité opposés pour stocker les électrons photogénérés. Dans un photodétecteur complet, il existe en outre un ou plusieurs transistors de lecture (non représentés) pour transférer les électrons.

La demande de brevet PCT WO2012/032495 expose que, quand les dimensions latérales de la surface éclairée ou surface photoréceptrice (la surface supérieure en figure 1) d'un photodétecteur sont faibles, de l'ordre de la longueur d'onde λ de la lumière que le photodétecteur est destiné à capter, ou longueur d'onde de fonctionnement, il se pose un problème pour introduire la lumière dans le photodétecteur. Ainsi, le rendement quantique de tels photodétecteurs est faible. Cette demande de brevet propose, pour augmenter le rendement quantique du photodétecteur, de disposer sur sa surface photoréceptrice un plot unique 2 dont les dimensions latérales sont inférieures aux dimensions latérales de la surface photoréceptrice et à la longueur d'onde de fonctionnement du photodétecteur.

La figure 2 représente de façon simplifiée et partielle la partie détectrice d'un photodétecteur de type diode à avalanche à photon unique, couramment désigné par l'acronyme SPAD (de l'anglais : "Single Photon Avalanche Diode"). Dans un tel photodétecteur, on trouve une structure constituée d'une couche semiconductrice 10, par exemple de type N, pincée entre deux couches semiconductrices 12 et 13 de type opposé. Le problème est que la couche 10 est, dans les technologies modernes, très mince, typiquement d'une épaisseur de l'ordre de 1 à 1,5 µm. C'est dans cette couche 10 que doit se faire la conversion utile des photons en paires électrons-trous, alors que l'on sait que, dans le cas du silicium et pour un rayonnement infrarouge, il faut que la couche dans laquelle doivent se créer les paires électrons trous ait une épaisseur supérieure à 10 µm, pour espérer obtenir un taux de conversion des photons supérieur à 90 %. Ainsi, le rendement (ou taux de conversion) d'un photodétecteur SPAD fabriqué par les technologies actuelles est seulement de l'ordre de 5 à 7 %. Pour améliorer ce rendement et ne pas perdre de lumière réfléchie, on dispose au-dessus de la couche supérieure semiconductrice 12 une structure antireflet, comprenant alternativement une couche de matériau à bas indice 14 en oxyde de silicium, et une couche de matériau à plus haut indice 15 en nitrure de silicium. Une couche de protection supérieure 16, en oxyde de silicium, surmonte la structure antireflet.

Ainsi, il se pose un problème pour absorber le maximum de photons possible dans des photodétecteurs de petites dimensions tels que ceux représentés en figure 1, et dans des photodétecteurs dans lesquels la couche semiconductrice de conversion de photons en paires électrons-trous est mince, tels que celui représenté en figure 2. Plus généralement, ce problème se pose de façon plus ou moins importante dans tous les photodétecteurs à semiconducteur.

On notera que, dans des photodétecteurs de petites dimensions ou des photodétecteurs de type SPAD, une augmentation, même faible, du rendement quantique ou taux d'absorption de la partie utile du photodétecteur est en pratique extrêmement importante pour la détection de lumière de faible intensité. Ainsi, un gain de rendement de 1 à 5 % sera considéré comme un gain important par l'utilisateur.

### Résumé

Ainsi, un mode de réalisation prévoit un photodétecteur comprenant une structure de conversion photoélectrique en un matériau semiconducteur, et, sur une surface photoréceptrice de la structure de conversion, un empilement de premier et deuxième éléments diffractants, le deuxième élément étant au-dessus du premier élément, dans lequel le premier élément comporte au moins un plot en un matériau d'indice optique n1 entouré latéralement par une région en un matériau d'indice optique n2 différent de n1 ; le deuxième élément comporte au moins un plot en un matériau d'indice optique n3 entouré latéralement par une région en un matériau d'indice optique n4 différent de n3 ; les plots des premier et deuxième éléments sont sensiblement alignés verticalement ; et les différences d'indices optiques n1-n2 et n3-n4 sont de signes opposés.

Selon un mode de réalisation, les plots des premier et deuxième éléments ont des dimensions latérales sensiblement identiques et inférieures à la longueur d'onde de fonctionnement du photodétecteur.

Selon un mode de réalisation, les dimensions de la surface photoréceptrice de la structure de conversion sont comprises entre 0,5 et 1,5 fois la longueur d'onde de fonctionnement du photodétecteur, et chacun des premier et deuxième éléments comprend un unique plot en le matériau d'indice optique n1, respectivement n3.

Selon un mode de réalisation, les dimensions de la surface photoréceptrice de la structure de conversion sont supérieures à 2 fois la longueur d'onde de fonctionnement du photodétecteur, et chacun des premier et deuxième éléments comprend un réseau périodique de plots en le matériau d'indice optique n1, respectivement n3.

Selon un mode de réalisation, dans chacun des premier et deuxième éléments, ledit au moins un plot et ladite région sont en des matériaux transparents à la longueur d'onde de fonctionnement du photodétecteur.

Selon un mode de réalisation, le photodétecteur comprend en outre une couche intermédiaire en un matériau transparent à la longueur d'onde de fonctionnement du photodétecteur, entre les premier et deuxième éléments.

Selon un mode de réalisation, la couche intermédiaire a une épaisseur comprise entre 40 et 150 nm et présente un indice optique supérieur à 2,5.

Selon un mode de réalisation, dans au moins l'un des premier et deuxième éléments, la région entourant latéralement ledit au moins un plot de l'élément est en un matériau conducteur et est reliée à une borne d'application d'un potentiel de polarisation.

Selon un mode de réalisation, les différences d'indices optiques n1-n2 et n3-n4 sont, en valeur absolue, supérieures ou égales à 1 et de préférence supérieures ou égales à 2.

Selon un mode de réalisation, dans l'un des premier et deuxième éléments, ledit au moins un plot et ladite région sont respectivement en silicium et en oxyde de silicium, et, dans l'autre des premier et deuxième éléments, ledit au moins un plot et ladite région sont respectivement en oxyde de silicium et en silicium.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, précédemment décrite, est une vue en coupe schématique et partielle de deux photodétecteurs de petites dimensions ;
la figure 2, précédemment décrite, est une vue en coupe schématique et partielle d'un photodétecteur de type SPAD ;
les figures 3A et 3B sont respectivement une vue en coupe et une vue de dessus représentant de façon schématique et partielle un exemple d'un mode de réalisation d'un photodétecteur ;
la figure 4 est une vue en coupe représentant de façon schématique et partielle une variante de réalisation du photodétecteur des figures 3A et 3B ; et
les figures 5A et 5B sont respectivement une vue en coupe et une vue de dessus représentant de façon schématique et partielle un exemple d'un autre mode de réalisation d'un photodétecteur.

### Description détaillée

De mêmes éléments ont été désignés par de mêmes références aux différentes figures et, de plus, les diverses figures ne sont pas tracées à l'échelle. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", "latéral", etc., ou à des qualificatifs d'orientation, tels que les termes "horizontal", "vertical", etc., il est fait référence à l'orientation des figures, étant entendu que, en pratique, les photodétecteurs décrits peuvent être orientés différemment. Sauf précision contraire, les expressions "approximativement", "sensiblement", et "de l'ordre de" signifient à 10 % près, de préférence à 5 % près.

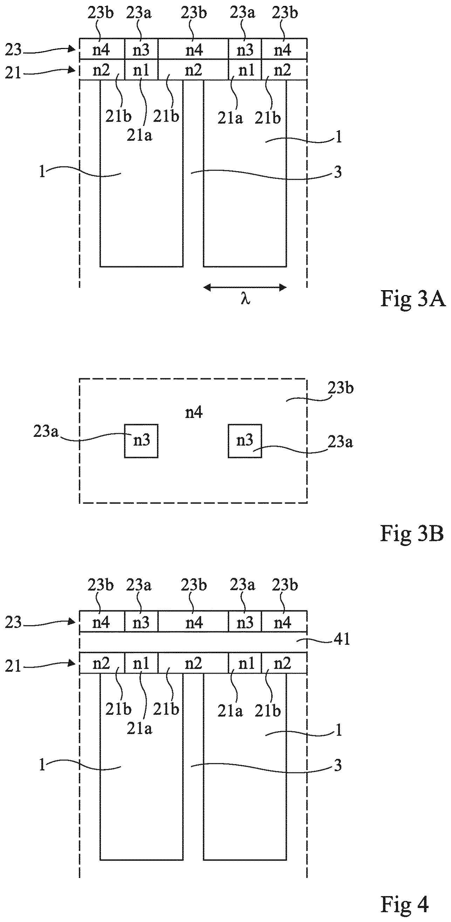

Les figures 3A et 3B représentent de façon schématique et partielle un exemple d'un mode de réalisation de deux photodétecteurs côte à côte d'un ensemble de photodétecteurs constituant par exemple un capteur d'image. Comme dans l'exemple de la figure 1, chaque photodétecteur comprend une structure 1 de conversion de photons en paires électrons-trous. La structure 1 est en un matériau semiconducteur, par exemple du silicium. Deux structures semiconductrices 1 voisines sont séparées, par exemple, par une région isolante 3. Les structures semiconductrices de conversion 1 sont représentées de façon très schématique. En pratique, chaque structure semiconductrice 1 comprend une ou plusieurs jonctions (non représentées) pour permettre un stockage de l'un des porteurs de chaque paire électron-trou photogénérée (couramment des électrons). Chaque photodétecteur peut en outre comporter un ou plusieurs transistors (non représentés), pour permettre notamment de transférer vers un circuit de lecture (non représenté) les charges photogénérées accumulées dans la structure semiconductrice de conversion 1.

On considère ici le cas dans lequel les dimensions latérales de la structure semiconductrice de photoconversion 1 sont de l'ordre de grandeur de la longueur d'onde λ de la lumière que le photodétecteur est destiné à capter, ou longueur d'onde de fonctionnement du capteur. A titre d'exemple, les dimensions latérales de la surface d'exposition à la lumière ou surface photoréceptrice de chaque photorécepteur (c'est-à-dire la surface supérieure de la structure 1 dans l'exemple représenté) sont comprises entre 0,5 et 1,5 fois la longueur d'onde de fonctionnement λ, laquelle est par exemple comprise entre 300 et 3000 nm, et de préférence comprise entre 600 et 3000 nm. On notera qu'en pratique, le capteur peut fonctionner dans une gamme comprenant plusieurs longueurs d'ondes. Ainsi, dans la présente description, on entend par longueur d'onde de fonctionnement la plus petite longueur d'onde d'une bande de longueurs d'ondes que le capteur est destiné à capter. A titre d'exemple, la bande de longueur d'onde que le capteur est destiné à capter présente une largeur comprise entre 1 et 500 nm.

Sur la surface photoréceptrice de la structure semiconductrice 1, est disposé un empilement vertical de deux éléments diffractants 21 et 23. L'élément 21 comprend un plot 21a en un matériau d'indice n1, disposé sur la surface photoréceptrice de la structure 1 (un plot par photorécepteur, préférentiellement centré selon l'axe vertical central du photodétecteur), entouré latéralement par une région 21b en un matériau d'indice optique n2 inférieur à n1. L'élément 23 comprend un plot 23a en un matériau d'indice n3, disposé sur la surface supérieure de l'élément diffractant 21, entouré latéralement par une région 23b en un matériau d'indice optique n4 supérieur à n3.

Les matériaux constitutifs des plots 21a et 23a et des régions périphériques 21b et 23b sont transparents à la longueur d'onde de fonctionnement λ du photodétecteur. Par "transparent", on entend que ces matériaux absorbent moins de 5 %, de préférence moins de 1 %, du rayonnement à cette longueur d'onde.

Les dimensions latérales des plots 21a et 23a sont inférieures aux dimensions latérales de la surface photoréceptrice de la structure semiconductrice 1 et à la longueur d'onde de fonctionnement du photodétecteur. A titre d'exemple, les dimensions latérales des plots 21a et 23a sont comprises entre le dixième et la moitié de la longueur d'onde de fonctionnement du photodétecteur.

Les dimensions latérales des plots 21a et 23a sont de préférence sensiblement identiques. De plus, les plots 21a et 23a sont de préférence sensiblement alignés verticalement, c'est-à-dire que, en projection verticale, les contours des plots 21a et 23a sont sensiblement confondus. A titre d'exemple, vu de dessus, la distance maximale séparant les contours des plots 21a et 23a est inférieure à 50 nm. De même, les dimensions latérales des régions périphériques 21b et 23b sont de préférence sensiblement identiques, et les régions périphériques 21b et 23b sont de préférence sensiblement alignées verticalement (par exemple avec la même tolérance de 50 nm).

Dans l'exemple représenté, les plots 21a et 23a ont, vu de dessus, une forme sensiblement carrée. Les modes de réalisation décrits ne se limitent toutefois pas à ce cas particulier. Plus généralement, les plots 21a et 23a peuvent avoir une forme quelconque, par exemple ronde, carrée, ovale ou rectangulaire.

L'épaisseur de chacun des éléments 21 et 23 est de préférence inférieure à la longueur d'onde de fonctionnement du photodétecteur, par exemple inférieure à la moitié de cette longueur d'onde. Les éléments 21 et 23 peuvent avoir sensiblement la même épaisseur ou des épaisseurs différentes. De préférence, les éléments 21 et 23 ont la même épaisseur. En effet, les essais réalisés ont montré qu'une meilleure absorption est obtenue dans le cas où les éléments 21 et 23 ont la même épaisseur.

A titre d'exemple, les éléments 21 et 23 recouvrent toute la surface photoréceptrice de la structure semiconductrice 1, étant entendu que, comme indiqué précédemment, les plots 21a et 21b recouvrent seulement une partie de cette surface photoréceptrice, le reste étant occupé par les régions périphériques 21b et 23b. Dans l'exemple représenté, les régions périphériques 21b des éléments 21 des différents photodétecteurs du capteur forment une couche continue revêtant sensiblement toute la surface du capteur à l'exception des parties recouvertes par les plots 21a. De même, dans cet exemple, les régions périphériques 23b des éléments 23 des différents photodétecteurs du capteur forment une couche continue revêtant sensiblement toute la surface du capteur à l'exception des parties recouvertes par les plots 23a.

La structure supérieure formée par les éléments diffractants 21 et 23 est par exemple revêtue d'une couche isolante de protection (non représentée), par exemple en oxyde de silicium, qui peut être surmontée d'une couche de filtrage (non représentée) et d'une microlentille propre à chaque photodétecteur (non représentées).

Dans chacun des éléments 21 et 23, l'écart d'indice optique entre le plot central 21a, respectivement 23a, et la région périphérique 21b, respectivement 23b, est de préférence relativement élevé, par exemple supérieur ou égal à 1 et de préférence supérieur ou égal à 2 en valeur absolue.

Les indices optiques n1 et n4 des régions de plus hauts indices 21a et 23b des éléments diffractants 21 et 23 sont par exemple inférieurs ou égaux à l'indice optique n_{sc} du matériau semiconducteur de la structure de photoconversion 1.

A titre d'exemple, le semiconducteur 1 peut être du silicium, d'indice optique n_{sc} de l'ordre de 3,6 (dans le domaine du proche infra-rouge, c'est-à-dire dans une gamme de longueurs d'onde allant de 800 à 1000 nm). Le plot 21a peut être réalisé dans le matériau semiconducteur de la structure 1 (n1=n_{sc}). La région périphérique 21b peut être en oxyde de silicium, d'indice optique de l'ordre de 1,45, et correspondre avantageusement (pour simplifier le procédé de fabrication) à une structure du type habituellement utilisée pour isoler des composants formés dans une même puce semiconductrice et couramment désignée par l'acronyme STI (de l'anglais "Shallow Trench Isolation" - isolation par tranchée peu profonde). La région 23b peut être en silicium polycristallin, d'indice optique de l'ordre de 3,5, et correspondre avantageusement (pour simplifier le procédé de fabrication) à une couche habituellement utilisée pour former des grilles conductrices dans le domaine de la fabrication de transistors MOS. Le plot 23a est par exemple en oxyde de silicium. Les modes de réalisation décrits ne se limitent toutefois pas à ces exemples particuliers. A titre de variante, le plot 21a peut être en silicium polycristallin, en silicium amorphe, en carbure de silicium, ou en nitrure de silicium. De plus, à titre de variante, la région périphérique 23b peut être en silicium amorphe, en carbure de silicium, ou en nitrure de silicium.

A titre de variante, les matériaux utilisés pour former le plot 21a et la région périphérique 21b de l'élément 21 d'une part, et les matériaux utilisés pour former le plot 23a et la région périphérique 23b d'autre part, peuvent être intervertis. Ainsi, dans l'élément 21, l'indice n1 du plot 21a peut être inférieur à l'indice n2 de la région 21b, et, dans l'élément 23, l'indice n3 du plot 23a peut être supérieur à l'indice n4 de la région 23b.

On notera que dans le cas où la région de haut indice optique de l'un et/ou l'autre des éléments diffractants 21 et 23 est en silicium polycristallin et est formée en même temps que des grilles conductrices de transistors MOS, une mince couche isolante, par exemple une couche d'oxyde de silicium d'épaisseur inférieure à 10 nm (correspondant à l'isolant de grille des transistors), peut faire interface entre cet élément et la structure sous-jacente, par exemple entre l'élément 23 et l'élément 21, ou entre l'élément 21 et la structure 1. De plus, un espaceur de faible épaisseur en un matériau isolant, par exemple un espaceur en nitrure de silicium d'épaisseur comprise entre 30 et 70 nm, peut séparer latéralement le silicium polycristallin, formant la région de plus haut indice de l'élément diffractant 21 ou 23, de l'oxyde de silicium formant la région de plus bas indice de l'élément diffractant.

On notera que si les régions 23b des éléments diffractants supérieurs 23 forment une couche conductrice continue s'étendant sur sensiblement toute la surface du capteur à l'exception des parties occupées par les plots 23a, on peut prévoir de relier la couche 23b à une borne d'application d'un potentiel de polarisation, par exemple au voisinage d'un bord du capteur. Ainsi, la couche 23b peut, en fonctionnement, être polarisée de manière à réduire les courants d'obscurité susceptibles de dégrader les performances des photodétecteurs. A titre d'exemple, la couche 23b peut être polarisée à un potentiel positif de façon à éviter que des électrons parasites générés au voisinage de la surface supérieure de la région semiconductrice 1 ne soient collectés par la région de collecte de charges photogénérées du photodétecteur.

A titre de variante, si les régions 21b des éléments diffractants inférieurs 21 forment une couche conductrice continue, et si cette couche est séparée de la région semiconductrice 1 par une couche isolante (par exemple si la couche 21b est en silicium polycristallin et est séparée du substrat par une mince couche d'oxyde de silicium), on peut prévoir, dans le même but, de relier la couche 21b à une borne d'application d'un potentiel de polarisation.

Comme cela sera exposé ci-après, on constate de façon surprenante qu'une structure du type décrit en relation avec les figures 3A et 3B, convenablement dimensionnée, augmente significativement le rendement de conversion des photons en paires électrons-trous par rapport à une structure du type représenté en figure 1. On aurait pu s'attendre à ce que la disposition, sur le trajet de la lumière, de deux éléments diffractants successifs présentant des agencements sensiblement complémentaires, n'engendre aucune augmentation du rendement quantique par rapport à un photodétecteur ne comportant pas ces éléments, ou tout du moins engendre une augmentation du rendement quantique plus faible que celle procurée par un seul élément diffractant (tel que représenté en figure 1). En effet, on aurait pu s'attendre à ce que les phénomènes de diffraction bénéfiques en termes de rendement provoqués par le premier élément diffractant soient contrebalancés au moins en partie par le deuxième élément diffractant. C'est cependant le contraire qui se produit, à savoir que l'empilement des deux éléments diffractants d'agencements complémentaires permet d'augmenter de plusieurs pourcents le rendement quantique par rapport à un photodétecteur à un seul élément diffractant.

La figure 4 est une vue en coupe représentant de façon schématique et partielle une variante de réalisation des photodétecteurs des figures 3A et 3B.

La structure de la figure 4 comprend les mêmes éléments que la structure des figures 3A et 3B. Ces éléments ne seront pas détaillés à nouveau.

La structure de la figure 4 diffère de la structure des figures 3A et 3B essentiellement en ce qu'elle comprend une couche supplémentaire 41 en un matériau transparent à la longueur d'onde de fonctionnement du photodétecteur, séparant l'élément diffractant 21 de l'élément diffractant 23.

On constate, comme cela sera exposé ci-après, que la présence de la couche d'interface 41 entre les éléments diffractants 21 et 23 permet d'augmenter encore le rendement quantique du photodétecteur par rapport à la structure des figures 3A et 3B. Plus particulièrement, dans le cas d'un substrat semiconducteur en silicium et d'éléments diffractants à base d'oxyde de silicium (formant la région de plus bas indice de l'élément diffractant) et de silicium (formant la région de plus haut indice de l'élément diffractant), une augmentation du rendement peut être obtenue lorsque la couche 41 présente une épaisseur comprise entre 40 et 150 nm et un indice optique supérieur à 2,5. Cette augmentation est tout particulièrement importante lorsque la couche 41 a une épaisseur comprise entre 50 et 80 nm et un indice optique de l'ordre de 3,6.

A titre d'exemple, la couche 41 peut être une couche de silicium polycristallin ou de silicium amorphe déposée sur la surface supérieure de l'élément diffractant 21.

A titre de variante, les matériaux de l'élément diffractant 21 sont respectivement du silicium monocristallin et de l'oxyde de silicium, l'élément diffractant 21 étant enterré sous une couche de silicium monocristallin formant la couche 41. Pour former une telle structure, on peut partir d'un premier substrat de silicium monocristallin dans lequel on forme la structure de photoconversion 1. L'élément diffractant 21 est formé du côté de la face avant d'un deuxième substrat de silicium monocristallin. Après la formation de l'élément diffractant 21, le deuxième substrat est rapporté sur le premier substrat, de façon que la surface photoréceptrice de la structure 1 soit tournée vers l'élément diffractant 21 (c'est-à-dire vers la face avant du deuxième substrat). Le deuxième substrat peut ensuite être aminci par sa face arrière de façon à ne conserver au-dessus de l'élément diffractant 21 qu'une mince épaisseur de silicium monocristallin correspondant à la couche 41. L'élément diffractant peut alors être formé sur la face supérieure de la couche 41.

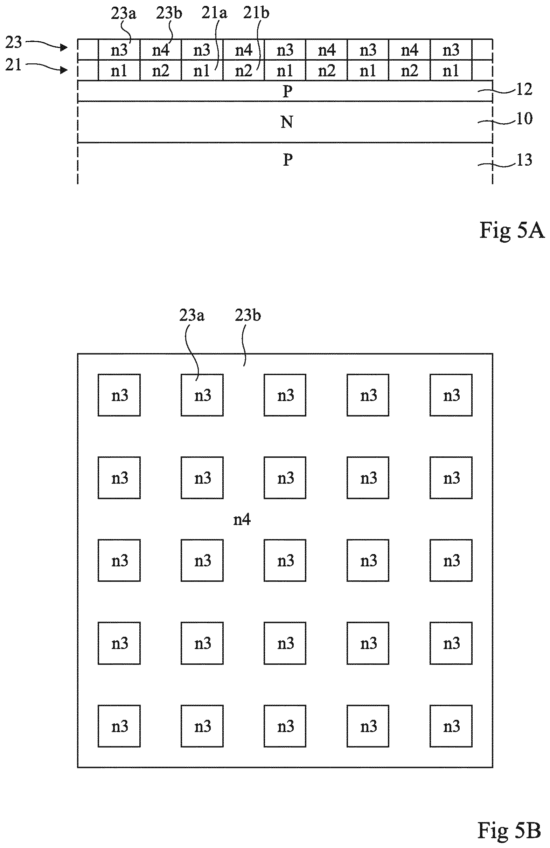

Les figures 5A et 5B sont respectivement une vue en coupe et une vue de dessus représentant de façon schématique et partielle un autre mode de réalisation d'un photodétecteur.

On considère cette fois le cas où les dimensions latérales de la structure semiconductrice de photoconversion du photodétecteur sont de l'ordre de plusieurs fois la longueur d'onde de fonctionnement du photodétecteur, par exemple supérieures à deux fois la longueur d'onde de fonctionnement, laquelle est par exemple comprise entre 300 et 3000 nm, et de préférence comprise entre 600 et 3000 nm.

A titre d'exemple, le photodétecteur des figures 5A et 5B est un photodétecteur de type SPAD, dont la structure semiconductrice de photoconversion comprend, comme dans l'exemple de la figure 2, une couche 10 de transformation de photons en paires électrons-trous d'un premier type de conductivité, par exemple de type N, encadrée par deux couches 12 et 13 du type de conductivité opposé.

Dans l'exemple des figures 5A et 5B, l'élément diffractant 21 comprend non plus un unique plot 21a (par photodétecteur) d'indice n1 entouré latéralement d'une région 21b d'indice n2 différent de n1, mais un réseau de plots périodique 21a (par photodétecteur) d'indice n1 séparés latéralement par la région 21b d'indice n2 qui forme une couche continue surmontant sensiblement toute la surface photoréceptrice à l'exception des portions surmontées par les plots 21a.

De plus, dans l'exemple des figures 5A et 5B, l'élément diffractant 23 comprend non plus un unique plot 23a d'indice n3 entouré latéralement d'une région 23b d'indice n4 différent de n3, mais un réseau de plots périodique 23a d'indice n3 séparés latéralement par la région 23b d'indice n4 qui forme une couche continue surmontant sensiblement toute la surface photoréceptrice à l'exception des portions surmontées par les plots 23a.

Les plots 21a, 23a et les régions 21b, 23b de séparation des plots sont de même type que ce qui a été décrit en relation avec les figures 3A et 3B. De plus, comme dans l'exemple des figures 3A et 3B, les plots 21a et 23a d'une part et les régions 21b et 23b d'autre part des éléments diffractants 21 et 23 sont sensiblement alignés verticalement.

A titre d'exemple, dans chacun des éléments diffractants 21 et 23, le pas de plots peut être égal aux deux tiers, à 30% près, de la longueur d'onde de fonctionnement du photodétecteur, les dimensions latérales des plots peuvent être comprises entre le dixième et la moitié de la longueur d'onde, et la distance entre les plots peut être de l'ordre du sixième aux deux tiers de la longueur d'onde.

La variante de réalisation de la figure 4 est transposable au mode de réalisation des figures 5A et 5B, à savoir que les éléments diffractants 21 et 23 de la figure 5A peuvent être séparés par une couche intermédiaire 41 du type décrit en relation avec la figure 4.

Des mesures comparatives ont été réalisées pour un photodétecteur de type SPAD, dans trois configurations distinctes A, B et C. Dans la configuration A, la photodiode SPAD est revêtue d'un seul réseau de plots périodique, par exemple le réseau 21 de la figure 5A. Dans la configuration B, la photodiode SPAD est revêtue d'un empilement de deux réseaux de plots périodiques 21 et 23 superposés, tel que représenté en figure 5A. Dans la configuration C, la photodiode SPAD est revêtue d'un empilement de deux réseaux de plots périodiques 21 et 23 séparés par une couche d'espacement 41 du type décrit en relation avec la figure 4.

On se place ici dans le cas où les plots 21a du réseau 21 sont en oxyde de silicium et sont séparés latéralement par une région continue 21b de silicium monocristallin (c'est-à-dire que le réseau 21 est formé dans la partie supérieure du substrat semiconducteur). Les plots 23a du réseau 23 sont en silicium polycristallin et sont séparés latéralement par une région continue 23b d'oxyde de silicium.

Dans les configurations A et B, les couches 10 et 12 de la photodiode SPAD sont des couches de silicium d'environ 1,5 et 0,7 µm d'épaisseur respectivement. L'épaisseur du réseau 21, c'est-à-dire la hauteur des plots 21a, est d'environ 300 nm. L'épaisseur du réseau 23, c'est-à-dire la hauteur des plots 23a, est d'environ 180 nm.

Dans la configuration C, les couches 10 et 12 de la photodiode SPAD sont des couches de silicium d'environ 1,5 et 0,8 µm d'épaisseur respectivement. Les réseaux 21 et 23 ont sensiblement la même épaisseur, de l'ordre de 240 nm.

Une étude paramétrique a été réalisée en faisant varier, dans chaque configuration, la largeur des plots du ou des réseaux, et la distance inter-plots.

Dans la configuration A, on constate qu'un taux d'absorption maximal de 10,2% peut être obtenu, avec une largeur de plots d'environ 380 nm et une distance inter-plots d'environ 160 nm.

Dans la configuration B, on constate que le taux d'absorption maximal monte à 12,6%, pour une largeur de plots d'environ 250 nm et une distance inter-plots d'environ 280 nm.

Dans la configuration C, un taux d'absorption maximal de 14,4% peut être obtenu, dans le cas où la couche intermédiaire 41 est une couche de silicium d'épaisseur comprise entre 50 et 80 nm, pour une largeur de plots d'environ 220 nm et une distance inter-plots d'environ 300 nm.

On notera que dans chacune des configurations susmentionnées, les taux d'absorption obtenus varient aussi en fonction des épaisseurs des réseaux 21 et/ou 23. Toutefois, on constate que quelles que soient les épaisseurs considérées, le rendement quantique maximal qui peut être atteint est toujours meilleur avec deux réseaux superposés (configuration B) qu'avec un seul réseau (configuration A), et est encore meilleur lorsque les deux réseaux sont séparés par la couche intermédiaire 41 (configuration C).

Des résultats similaires sont par ailleurs observés lorsque les types des réseaux sont inversés, c'est-à-dire lorsque les plots du réseau 21 sont en un matériau de haut indice et sont séparés deux à deux par un matériau de bas indice, et lorsque les plots du réseau 23 sont en un matériau de bas indice et sont séparés deux à deux par un matériau de haut indice.

De façon générale, l'homme de métier pourra réaliser une optimisation des dimensions des plots par des procédés classiques de simulation, en utilisant des programmes de simulation tels que le logiciel DiffractMOD (www.rsoftdesign.com) ou le logiciel Grating Toolbox (www.lighttrans com). Ainsi, moyennant ce calcul de simulation préalable, l'homme de l'art pourra, sans tâtonnement, dimensionner les éléments diffractants 21 et 23 et, le cas échéant, la couche intermédiaire 41 pour augmenter le rendement quantique ou taux d'absorption de photons d'une photodiode.

Des modes de réalisation particuliers ont été décrits. Diverses variantes et modifications apparaîtront à l'homme de l'art. En particulier, les matériaux constituant les éléments diffractants 21 et 23 peuvent être différents des exemples susmentionnés, à condition qu'ils soient transparents à la longueur d'onde de fonctionnement et qu'ils respectent les relations exposées précédemment entre les indices n1, n2, n3 et n4, à savoir que les différences n1-n2 et n3-n4 soient non nulles et soient de signes opposés.

Dans les modes de réalisation décrits, pour obtenir une amélioration significative du rendement quantique, les plots 21a, 23a sont de préférence dimensionnés en tenant compte non seulement de la plus petite longueur d'onde λ que le capteur est destiné à capter, mais aussi de la plus grande longueur d'onde A que le capteur est destiné à capter. En particulier, la période (ou pas) des plots 21a, respectivement 23a est de préférence inférieure à λ/n_{inc}, n_{inc} étant l'indice optique du milieu incident (le milieu situé en amont des éléments diffractants 21 et 23), de façon à éviter la diffraction dans le milieu incident, et supérieure à Λ/n_{sc}, n_{sc} étant l'indice optique du matériau semiconducteur de la structure 1, de façon à avoir de la diffraction dans le milieu semiconducteur 1.

## Revendications

1. Photodétecteur comprenant une structure de conversion photoélectrique en un matériau semiconducteur, et, sur une surface photoréceptrice de la structure de conversion, un empilement de premier (21) et deuxième (23) éléments diffractants, le deuxième élément étant au-dessus du premier élément, dans lequel :
le premier élément (21) comporte au moins un plot (21a) en un matériau d'indice optique n1 entouré latéralement par une région (21b) en un matériau d'indice optique n2 différent de n1 ;
le deuxième élément (23) comporte au moins un plot (23a) en un matériau d'indice optique n3 entouré latéralement par une région (23b) en un matériau d'indice optique n4 différent de n3 ;
les plots (21a, 23a) des premier et deuxième éléments sont sensiblement alignés verticalement ; les différences d'indices optiques n1-n2 et n3-n4 sont de signes opposés ; et
les plots (21a, 23a) des premier (21) et deuxième (23) éléments ont des dimensions latérales sensiblement identiques et inférieures à la longueur d'onde de fonctionnement du photodétecteur.

2. Photodétecteur selon la revendication 1, dans lequel les dimensions de la surface photoréceptrice de la structure de conversion sont comprises entre 0,5 et 1,5 fois la longueur d'onde de fonctionnement du photodétecteur, et dans lequel chacun des premier (21) et deuxième (23) éléments comprend un unique plot (21a, 23a) en le matériau d'indice optique n1, respectivement n3.

3. Photodétecteur selon la revendication 1, dans lequel les dimensions de la surface photoréceptrice de la structure de conversion sont supérieures à 2 fois la longueur d'onde de fonctionnement du photodétecteur, et dans lequel chacun des premier (21) et deuxième (23) éléments comprend un réseau périodique de plots (21a, 23a) en le matériau d'indice optique n1, respectivement n3.

4. Photodétecteur selon l'une quelconque des revendications 1 à 3, dans lequel, dans chacun des premier (21) et deuxième (23) éléments, ledit au moins un plot (21a, 23a) et ladite région (21b, 23b) sont en des matériaux transparents à la longueur d'onde de fonctionnement du photodétecteur.

5. Photodétecteur selon l'une quelconque des revendications 1 à 4, comprenant en outre une couche intermédiaire (41) en un matériau transparent à la longueur d'onde de fonctionnement du photodétecteur, entre les premier (21) et deuxième (23) éléments.

6. Photodétecteur selon la revendication 5, dans lequel ladite couche intermédiaire (41) a une épaisseur comprise entre 40 et 150 nm et présente un indice optique supérieur à 2,5.

7. Photodétecteur selon l'une quelconque des revendications 1 à 6, dans lequel, dans au moins l'un des premier (21) et deuxième (23) éléments, la région (21b, 23b) entourant latéralement ledit au moins un plot (21a, 23a) de l'élément est en un matériau conducteur et est reliée à une borne d'application d'un potentiel de polarisation.

8. Photodétecteur selon l'une quelconque des revendications 1 à 7, dans lequel les différences d'indices optiques n1-n2 et n3-n4 sont, en valeur absolue, supérieures ou égales à 1 et de préférence supérieures ou égales à 2.

9. Photodétecteur selon l'une quelconque des revendications 1 à 8, dans lequel, dans l'un des premier (21) et deuxième (23) éléments, ledit au moins un plot (21a, 23a) et ladite région (21b, 23b) sont respectivement en silicium et en oxyde de silicium, et, dans l'autre des premier (21) et deuxième (23) éléments, ledit au moins un plot (21a, 23a) et ladite région (21b, 23b) sont respectivement en oxyde de silicium et en silicium.

## Patentansprüche

1. Fotodetektor, der Folgendes aufweist:
eine fotoelektrische Umwandlungsstruktur aus einem Halbleitermaterial und auf einer Licht-empfangenden Oberfläche der Umwandlungsstruktur einen Stapel von ersten (21) und zweiten (23) beugenden Elementen, wobei das zweite Element oberhalb des ersten Elements ist, und wobei:
das erste Element (21) wenigstens ein Pad (21a) aufweist, das aus einem Material besteht, das einen optischen Index n1 besitzt, und seitlich umgeben ist von einem Bereich (21b), der aus einem Material besteht, das einen optischen Index n2 besitzt, der sich von n1 unterscheidet;
das zweite Element (23) wenigstens ein Pad (23a) aufweist, das aus einem Material besteht, das einen optischen Index n3 besitzt, und seitlich umgeben ist von einem Bereich (23b), der aus einem Material besteht, das einen optischen Index n4 besitzt, der sich von n3 unterscheidet;
die Pads (21a, 23a) der ersten und zweiten Elemente im Wesentlichen vertikal ausgerichtet sind;
optische Indexunterschiede n1-n2 und n3-n4 entgegengesetzte Zeichen haben; und
die Pads (21a, 23a) der ersten (21) und zweiten (23) Elemente im Wesentlichen identische seitliche Dimensionen haben, die kleiner sind als die Betriebswellenlänge des Fotodetektors.

2. Fotodetektor nach Anspruch 1, wobei die Dimensionen der Licht-empfangenden Oberfläche der Umwandlungsstruktur in einem Bereich von 0,5 bis 1.5 mal der Betriebswellenlänge des Fotodetektors sind, und wobei jedes der ersten (21) und zweiten (23) Elemente ein einzelnes Pad (21a, 23a) aufweist, das aus einem Material des optischen Index n1 beziehungsweise n3 besteht.

3. Fotodetektor nach Anspruch 1, wobei die Dimensionen der Licht-empfangenden Oberfläche der Umwandlungsstruktur größer sind als 2-mal die Betriebswellenlänge des Fotodetektors und wobei jedes der ersten (21) und zweiten (23) Elemente ein regelmäßiges Gitter von Pads (21a, 23a) aufweist, das aus einem Material des optischen Index n1 beziehungsweise n3 besteht.

4. Fotodetektor nach einem der Ansprüche 1 bis 3, wobei in jeder der ersten (21) und zweiten (23) Elemente wenigstens ein Pad (21a, 23a) und der Bereich (21b, 23b) aus Materialien bestehen, die transparent sind für die Betriebswellenlänge des Fotodetektors.

5. Fotodetektor nach einem der Ansprüche 1 bis 4, der ferner eine Zwischenschicht (41) aufweist, die aus einem Material besteht, das transparent ist für die Betriebswellenlänge des Fotodetektors zwischen den ersten (21) und zweiten (23) Elementen.

6. Fotodetektor nach Anspruch 5, wobei die Zwischenschicht (41) eine Dicke im Bereich von 40 bis 150 nm und einen optischen Index größer als 2,5 besitzt.

7. Fotodetektor nach einem der Ansprüche 1 bis 6, wobei in wenigstens einem der ersten (21) und zweiten (23) Elemente der Bereich (21b, 23b), der das wenigstens eine Pad (21a, 23a) des Elements seitlich umgibt, aus einem leitenden Material hergestellt ist und verbunden ist mit einem Anschluss zum Anlegen einer Vorspannung.

8. Fotodetektor nach einem der Ansprüche 1 bis 7, wobei die optischen Indexunterschiede n1-n2 und n3-n4 im Absolutwert größer oder gleich zu 1 sind und vorzugsweise größer oder gleich zu 2.

9. Fotodetektor nach einem der Ansprüche 1 bis 8, wobei in einem der ersten (21) und zweiten (23) Elemente das wenigstens eine Pad (21a, 23a) und der Bereich (21b, 23b) jeweils aus Silicium und Siliciumoxid bestehen, und in dem anderen der ersten (21) und zweiten (23) Elemente das wenigstens eine Pad (21a, 23a) und der Bereich (21b, 23b) jeweils aus Siliciumoxid und Silicium bestehen.

## Claims

1. A photodetector comprising a photoelectric conversion structure made of a semiconductor material and, on a light-receiving surface of the conversion structure, a stack of first (21) and second (23) diffractive elements, the second element being above the first element, wherein:
the first element (21) comprises at least one pad (21a) made of a material having an optical index n1, laterally surrounded with a region (21b) made of a material having an optical index n2 different from n1;
the second element (23) comprises at least one pad (23a) made of a material having an optical index n3, laterally surrounded with a region (23b) made of a material having an optical index n4 different from n3;
the pads (21a, 23a) of the first and second elements are substantially vertically aligned;
optical index differences n1-n2 and n3-n4 have opposite signs; and
the pads (21a, 23a) of the first (21) and second (23) elements have substantially identical lateral dimensions smaller than the operating wavelength of the photodetector.

2. The photodetector of claim 1, wherein the dimensions of the light-receiving surface of the conversion structure are in the range from 0.5 to 1.5 time the operating wavelength of the photodetector, and wherein each of the first (21) and second (23) elements comprises a single pad (21a, 23a) made of the material of optical index n1, respectively n3.

3. The photodetector of claim 1, wherein the dimensions of the light-receiving surface of the conversion structure are greater than 2 times the operating wavelength of the photodetector, and wherein each of the first (21) and second (23) elements comprises a periodic grating of pads (21a, 23a) made of the material of optical index n1, respectively n3.

4. The photodetector of any of claims 1 to 3, wherein, in each of the first (21) and second (23) elements, said at least one pad (21a, 23a) and said region (21b, 23b) are made of materials transparent to the operating wavelength of the photodetector.

5. The photodetector of any of claims 1 to 4, further comprising an intermediate layer (41) made of a material transparent to the operating wavelength of the photodetector, between the first (21) and second (23) elements.

6. The photodetector of claim 5, wherein said intermediate layer (41) has a thickness in the range from 40 to 150 nm and has an optical index greater than 2.5.

7. The photodetector of any of claims 1 to 6, wherein, in at least one of the first (21) and second (23) elements, the region (21b, 23b) laterally surrounding said at least one pad (21a, 23a) of the element is made of a conductive material and is connected to a terminal of application of a bias voltage.

8. The photodetector of any of claims 1 to 7, wherein optical index differences n1-n2 and n3-n4 are, in absolute value, greater than or equal to 1, and preferably greater than or equal to 2.

9. The photodetector of any of claims 1 to 8, wherein, in one of the first (21) and second (23) elements, said at least one pad (21a, 23a) and said region (21b, 23b) are respectively made of silicon and of silicon oxide and, in the other one of the first (21) and second (23) elements, said at least one pad (21a, 23a) and said region (21b, 23b) are respectively made of silicon oxide and of silicon.
